# EUROPÄISCHE PATENTSCHRIFT

(11) **EP 1 626 440 B1**
(45) Veröffentlichungstag und Bekanntmachung des Hinweises auf die Patenterteilung: **14.11.2007**
(21) Anmeldenummer: 05021844.5
(22) Anmeldetag: 27.06.2002
(51) Int. Cl.: H01L 21/762, H01L 21/20

(54) **SOI-Scheibe**
SOI wafer
Plaquette SOI

(30) Priorität: 28.06.2001 DE 10131249
(43) Veröffentlichungstag der Anmeldung: 15.02.2006
(62) Teilanmeldung aus: 02758281.6
(73) Patentinhaber: Siltronic AG, 81737 München (DE)
(72) Erfinder: Murphy, Brian, 84347 Pfarrkirchen (DE); Wahlich, Reinhold, 84529 Tittmoning (DE); Schmolke, Rüdiger, Dr., 84489 Burghausen (DE); Ammon von, Wilfried, Dr., 5122 Hochburg/Ach (AT); Moreland, James, Dr., Portland, OR 97229 (US)
(74) Vertreter: Baar, Christian

(56) Entgegenhaltungen:
- EP-A- 0 966 034
- EP-A- 1 193 740
- TATE N ET AL: "Defect reduction of bonded SOI wafers by post anneal process in H2 ambient" SOI CONFERENCE, 1998. PROCEEDINGS., 1998 IEEE INTERNATIONAL STUART, FL, USA 5-8 OCT. 1998, NEW YORK, NY, USA,IEEE, US, 5. Oktober 1998 (1998-10-05), Seiten 141-142, XP010309913 ISBN: 0-7803-4500-2
- AGA H ET AL: "STUDY OF HF DEFECTS IN THIN, BONDED SILICON-ON-INSULATOR DEPENDENT ON ORIGINAL WAFERS" JAPANESE JOURNAL OF APPLIED PHYSICS, JAPAN SOCIETY OF APPLIED PHYSICS, TOKYO, JP, Bd. 38, Nr. 5A, Mai 1999 (1999-05), Seiten 2694-2698, XP000906245 ISSN: 0021-4922
- ALLES M L ET AL: "Analysis of thin film SOI material defect requirements for advanced circuit applications YDRAMs" SOI CONFERENCE, 1997. PROCEEDINGS., 1997 IEEE INTERNATIONAL FISH CAMP, CA, USA 6-9 OCT. 1997, NEW YORK, NY, USA,IEEE, US, 6. Oktober 1997 (1997-10-06), Seiten 128-129, XP010256238 ISBN: 0-7803-3938-X

## Beschreibung

Gegenstan der Erfindung ist eine SOI-Scheibe.

So genannte SOI-Scheiben ("silicon on insulator") haben eine Schichtstruktur, in der Regel bestehend aus einem Träger, beispielsweise einer Siliciumscheibe, einer nahe unter der Oberfläche vergrabenen Oxidschicht sowie einer dünnen Siliciumschicht auf der Oxidschicht. Diese Schichtstruktur hat bei der Herstellung von elektronischen Bauelementen (z. B. Speicher und Mikroprozessoren) gegenüber den herkömmlich verwendeten Siliciumscheiben wesentliche Vorteile:

Es wird eine bessere Charakteristik der elektronischen Funktionen, verbunden mit höheren Schaltgeschwindigkeiten und einem geringeren Leistungsverbrauch des Bauelements erreicht. Zudem sind auf der Basis von SOI-Scheiben hergestellte Bauelemente besser für den Betrieb bei niedrigeren Spannungen geeignet als herkömmliche Bauelemente.

Aus diesen Gründen wird bei zukünftigen Bauelemente-Generationen der Einsatz von SOI-Scheiben wesentlich zunehmen. Die Qualitätsanforderungen an die SOI-Scheiben sind hoch, insbesondere an die Schichtdicken-Homogenitäten und die Defektdichten in der dünnen Siliciumschicht und in der Oxidschicht. Hier unterscheiden sich auch die verschiedenen Herstellungsverfahren und Produkte nach dem Stand der Technik:

Beispielsweise wird beim sog. SIMOX-Prozess durch die Implantation von Sauerstoff-Ionen durch die Oberfläche einer Siliciumscheibe in einer definierten Tiefe, die durch die Energie der Sauerstoff-Ionen bestimmt ist, eine Schicht mit hohem Sauerstoffgehalt erzeugt (Izumi et al., Electron Lett. 14 (18) (1978), p. 593). Diese Schicht wird in einer nachfolgenden thermischen Behandlung in eine Siliciumoxid-Schicht umgewandelt, die die darüber liegende dünne Siliciumschicht von dem darunter liegenden Rest der Siliciumscheibe trennt. Durch die Implantation der Sauerstoff-Ionen werden jedoch Kristallfehler ("Damage") in der dünnen Siliciumschicht erzeugt, die sich bei einer nachfolgenden Herstellung von elektronischen Bauelementen auf der SOI-Scheibe nachteilig auswirken.

Meist werden SOI-Scheiben allerdings durch den Transfer einer dünnen Siliciumschicht von einer ersten Scheibe, der Substratscheibe, auf eine zweite Scheibe, die Trägerscheibe, hergestellt. In der Regel bestehen beide Scheiben aus Silicium. Die dünne Siliciumschicht wird beispielsweise über eine isolierende Siliciumoxid-Schicht mit der Trägerscheibe verbunden. Es sind mehrere Verfahren bekannt, die für den Transfer dünner Siliciumschichten von einer ersten Scheibe auf eine zweite Scheibe und damit zur Herstellung einer SOI-Scheibe eingesetzt werden können:

Bei dem als Smart Cut™ bezeichneten Prozess (US5374564; EP0807970A1; Weldon et al., J. Vac. Sci. Technolo., B 15(4) (1997), pp. 1065-1073) wird die Trennschicht mittels einer Wasserstoff-Implantation hergestellt, nach dem Verbinden ("Bonding") der zwei Scheiben erfolgt die Trennung ("Splitting") mittels thermischer Behandlung. Dabei entsteht eine relativ raue Oberfläche mit vielen Defekten, die anschließend durch Politur oder thermische Behandlung ("Anneal") geglättet werden muss. Es entstehen dabei auch nicht reparable Defekte (Löcher), sog. HF-Defekte, in der dünnen oberen Siliciumschicht mit einer Dichte von 0,1/cm² - 0,5/cm². Weiterhin entstehen durch die Implantation, die verwendete Trennschicht und das Trennverfahren Defekte in der oberen Siliciumschicht, die nach einem Secco-Ätzschritt sichtbar werden ("Secco etch defects") in der Größenordnung von 1·10²/cm² bis etwa 1·10⁴/cm² (J. G. Park, "Nature of Surface Defects in SOI wafers: SIMOX vs. Bonded SOI", JSPS, 3. International Symposium on Advanced Science and Technology of Silicon Material, 2000, Kona, USA).

Im so genannten ELTRAN-Prozess (US5854123; EP0553852A2; Yonehara et al., Electrochem. Soc. Proc. 99-3 (1999) pp. 111-116) wird die Trennschicht mittels eines anodischen Ätzverfahrens hergestellt, wobei eine poröse Oberflächenschicht entsteht. Diese bildet die Trennschicht. Anschließend wird auf dieser porösen Schicht eine epitaktische Schicht abgeschieden, die die spätere dünne Siliciumschicht bildet. Die Trennung erfolgt mechanisch, wobei sich hier wiederum Defekte in der Oberfläche sowie in der oberen Siliciumschicht bilden. Des weiteren kann die epitaktische Schicht nicht vollkommen störungsfrei auf der porösen Oberfläche aufwachsen. Die HF-Defektdichte (Löcher in der dünnen Siliciumschicht) beträgt 0,1/cm² - 0,3/cm², die Dichte der Secco-Etch-Defekte liegt bei 5·10²/cm² - 1·10⁵/cm² je nach Schichtdicke der Siliciumschicht. Die Oberflächenrauhigkeit nach dem Splitting ist hoch mit 5 nm rms (scanning area 1 µm x 1 µm) und erfordert nachgeschaltete Glättungsverfahren. (Sakaguchi et al., Solid State Technology 43 (6) (2000) pp. 88-92).

Ein weiteres Verfahren ist der so genannte Nano-cleave-Prozess der Fa. SiGen, USA (Current et al., European Semiconductor, 22(2) (2000) pp. 25-27). In diesem Verfahren ist ein zusätzlicher Glättungsschritt nach der Trennung notwendig, um Rauhigkeitswerte unter 0,2 nm rms zu erzeugen (Thilderkvist et al., IEEE SOI Symposium, 2000, Wakefield, USA).

Es werden daher aufwendige Nachbehandlungsschritte durchgeführt, um die genannten Nachteile zu kompensieren. Beispielsweise wird gemäß der EP0905767A1 die SOI-Scheibe durch ein Gasphasen-Ätzverfahren von der durch die Spaltung der Siliciumscheibe entlang der Schicht der Wasserstoff-Blasen erzeugten Defektschicht befreit. Dieses Verfahren erlaubt gleichzeitig eine eventuell gewünschte Dickenreduktion der Siliciumschicht. Die gleiche Wirkung wird durch eine thermische Oxidation der Silicium-Oberfläche und anschließende reduktive Entfernung des Siliciumoxids, wie in EP1045448A1 beschrieben, erzielt. Möglich ist auch eine thermische Behandlung der SOI-Scheibe in einer wasserstoffhaltigen Atmosphäre, um die Oberfläche der dünnen Siliciumschicht zu glätten und Kristalldefekte auszuheilen (EP1045448A1).

Der Erfindung liegt somit die Aufgabe zu Grunde, einen Film oder eine Schicht aus halbleitendem Material, der bzw. die weitgehend frei von Kristalldefekten ist und eine glatte Oberfläche aufweist.

Die Erfindung bezieht sich auf einen Film oder eine Schicht aus halbleitendem Material, dadurch gekennzeichnet, dass die Defektdichte in der dünnen Schicht bei den HF-Defekten kleiner als 0,1/cm² und bei den Secco-Etch-Defekten kleiner als 10/cm² ist.

Weiterhin bezieht sich die Erfindung auf eine SOI-Scheibe, bestehend aus einer Trägerscheibe und einer dünnen Siliciumschicht, dadurch gekennzeichnet, dass die Siliciumschicht nach dem Trennen eine geringere Oberflächenrauhigkeit als 0,2 nm rms und eine Defektdichte bei den HF-Defekten kleiner als 0,1/cm² und bei den Secco-Etch-Defekten kleiner als 10/cm² aufweist.

Die Erfindung bezieht sich auch auf eine SOI-Scheibe, bestehend aus einer Trägerscheibe und einer dünnen Siliciumschicht, dadurch gekennzeichnet, dass die dünne Siliciumschicht eine Dicke von 20 nm oder weniger und eine Dickenvariation von 5 % oder weniger aufweist.

### Beschreibung der Figuren:

Fig. 1 zeigt schematisch den Ablauf des erfindungsgemäßen Verfahrens zur Herstellung eines Films oder einer Schicht aus halbleitendem Material.
Fig. 2 zeigt den Ablauf einer bevorzugten Ausführungsform des erfindungsgemäßen Verfahrens, bei dem der Film bzw. die Schicht auf ein Trägermaterial transferiert wird.
Fig. 3 ist eine SEM-Aufnahme ("scanning electron microscope") eines Schnitts durch eine erfindungsgemäß den Schritten a) und b) unterworfene Siliciumscheibe.
Fig. 4 ist eine SEM-Aufnahme der in Fig. 3 dargestellten Siliciumscheibe, nachdem diese dem Trennschritt c) unterzogen wurde.

Im Folgenden wird anhand der Figuren das erfindungsgemäße Verfahren zur Herstellung eines Films oder einer Schicht eines halbleitenden Materials zusammen mit bevorzugten Ausführungsformen beschrieben. Das Herstellverfahren ist dargestellt als Kombination von Einzelschritten a) bis c), wobei jeder Einzelschritt fallweise Variationsmöglichkeiten beinhalten kann.

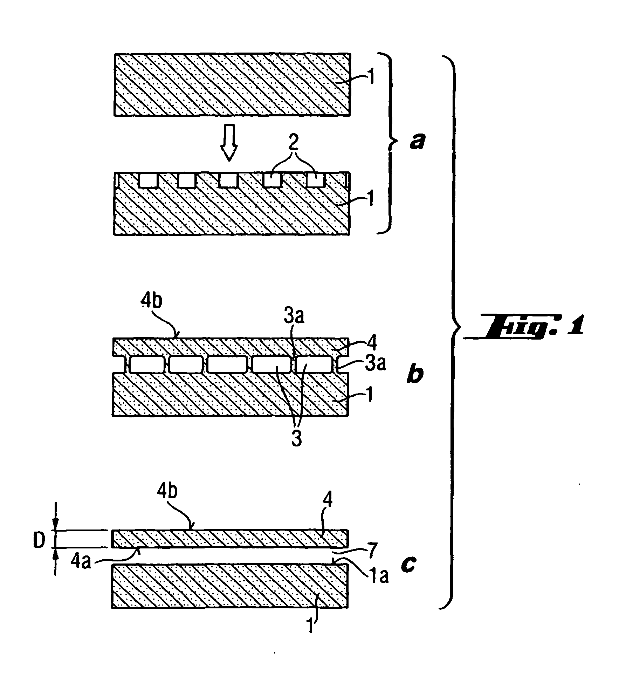

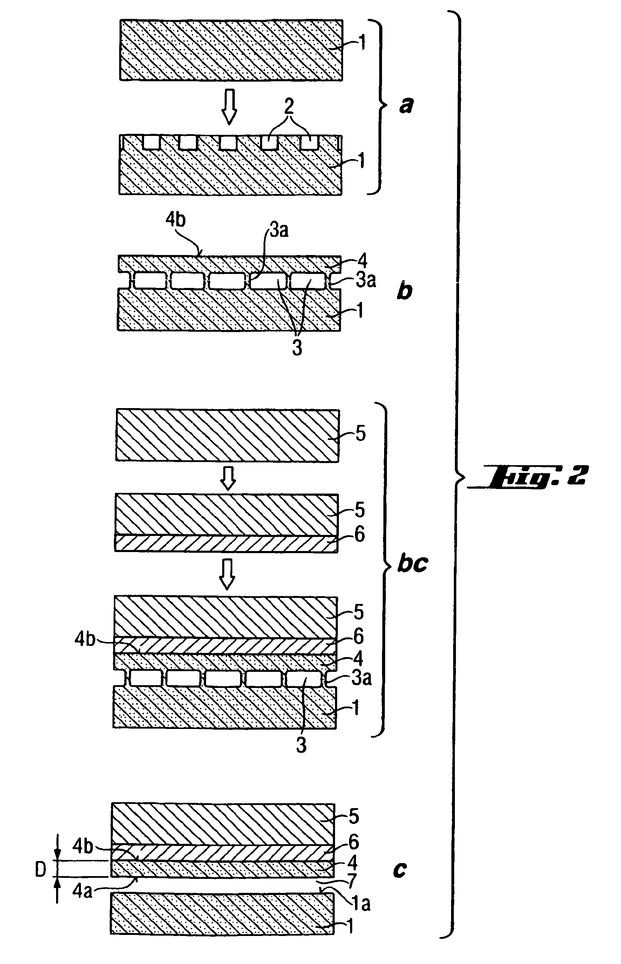

Im ersten Schritt a) werden auf der Oberfläche, ggf. auch auf einem Teil der Oberfläche des halbleitenden Ausgangsmaterials (Substrats) 1 Strukturen aus sich periodisch wiederholenden Vertiefungen 2 vorgegebener Geometrien erzeugt (in Fig. 1 und 2 schematisch dargestellt).

Das Verfahren kann auf beliebige halbleitende Materialien angewendet werden, bevorzugt jedoch auf Silicium-Germanium, Galliumarsenid, Siliciumcarbid und Indiumphosphid, besonders bevorzugt auf Silicium. Da Silicium bei der Herstellung von Halbleiterbauelementen von herausragender Bedeutung ist, werden die Vorteile und die bevorzugten Ausführungsformen des erfindungsgemäßen Verfahrens an Hand von Silicium erläutert, auch wenn die Anwendung nicht auf Silicium beschränkt ist.

Das Substrat kann aus verschiedenen Materialspezifikationen bestehen, wobei besonders die Ausführung des oberflächennahen Bereichs einen wesentlichen Einfluss auf die spätere Qualität der halbleitenden Schicht hat, da aus der Oberflächenschicht des Substrats der Film oder die Schicht aus halbleitendem Material entsteht.

Bevorzugt ist der Einsatz von scheibenförmigen Substraten mit ebenen Oberflächen. Besonders bevorzugt werden monokristalline Siliciumscheiben eingesetzt: CZ- oder FZ-Scheiben (d. h. Scheiben aus Einkristallen, die nach dem Czochralski-Verfahren bzw. dem Floating-Zone-Verfahren hergestellt wurden) mit beliebigen Dotierungen und Co-Dotierungen (beispielsweise stickstoffdotierte Scheiben), mit einer epitaktischen Schicht versehene Scheiben, thermisch behandelte Scheiben sowie Material ohne nennenswerte Leerstellen und interstitielle Konglomerate ("void free silicon" oder "perfect silicon") oder isotopenreines Silicium (²⁸Si).

Neu ist, dass neben der bekannten Oberflächenqualität "poliert" und "doppelseitenpoliert (DSP)" auch Scheiben ohne Spiegelpolitur (nicht haze-frei), feingeschliffene Scheiben ("fine ground") oder geätzte Scheiben eingesetzt werden können.

Die Erzeugung der Vertiefungen 2 (Fig. 1 und 2) in der oberflächennahen Schicht im Schritt a) erfolgt mit den bekannten Verfahren der Photolithographie, der Masken- und Belichtungstechnik, dem Trench-Ätzen mittels Ionenstrahlätztechnik, dem Plasmaätzen, mit Hilfe eines Lasers oder ähnlicher Verfahren (Buch: "Silicon processing for the VLSI Era", S. Wolf, ISBN 0-961672-16-1). Die Dimensionen dieser Vertiefungen ("Trenches") 2 werden dabei hinsichtlich Breite, Durchmesser, Tiefe, Form und Abstand genau vorgegeben. Möglich sind Löcher, Gräben oder andere regelmäßige oder unregelmäßige geometrische Formen, wobei regelmäßige Formen bevorzugt und im Wesentlichen runde oder quadratische Löcher besonders bevorzugt sind.

Die Vertiefungen 2 werden in hoher Dichte auf einem Teilbereich der Oberfläche oder, bevorzugt, im Wesentlichen auf einer ganzen Fläche des Substrats 1 erzeugt. Beispielsweise wird bei scheibenförmigen Substraten bevorzugt eine der beiden Flächen im Wesentlichen ganzflächig mit Vertiefungen versehen. Die Vertiefungen werden derart erzeugt, dass Strukturen aus sich periodisch wiederholenden Vertiefungen vorgegebener Geometrien entstehen. Die geometrischen Abmessungen (d. h. im Wesentlichen Querschnitt, Tiefe und Abstand) der Vertiefungen werden so gewählt, dass die im weiteren Prozessverlauf entstehende Schicht aus halbleitendem Material die gewünschte Dicke D erhält. Dazu werden bevorzugt für den Durchmesser (bei runden Löchern) bzw. die Kantenlänge (bei quadratischen Löchern) D/5 bis 2·D (besonders bevorzugt D/3 bis D), für die Trenchtiefe D bis 4·D und den Trenchabstand D/2 bis 3·D gewählt.

Die geometrischen Abmessungen der Vertiefungen werden beispielsweise so gewählt, dass bei der nachfolgenden thermischen Behandlung in Schritt b) die aus den Vertiefungen entstehenden individuellen Hohlräume 3 zu größeren Hohlräumen 3 zusammenwachsen können. (Die in den Fig. 1 und 2 dargestellten Hohlräume 3 symbolisieren sowohl die individuellen Hohlräume als auch die größeren Hohlräume.) Bevorzugt werden in diesem Fall die Vertiefungen an wenigen genau positionierten Stellen in größeren Abständen erzeugt, sodass nach Schritt b) noch Stege 3a im Hohlraum 3 verbleiben.

Besonders bevorzugt ist es jedoch, die Löcher, die vorzugsweise alle die gleiche Geometrie aufweisen, in einem regelmäßigen, beispielsweise quadratischen oder hexagonalen Raster mit gleichbleibenden Loch-Loch-Abständen zu erzeugen und auf größere Abstände an bestimmten Stellen zu verzichten. Die geometrischen Abmessungen der Löcher sowie der Loch-Loch-Abstand werden in diesem Fall vorzugsweise so gewählt, dass bei der thermischen Behandlung gemäß Schritt b) die Oberfläche durch eine glatte Schicht geschlossen wird, die individuellen, aus den einzelnen Vertiefungen entstandenen Hohlräume aber noch nicht zu größeren Hohlräumen verschmelzen.

Im nachfolgenden Schritt b) wird das Substrat einer thermischen Behandlung unterzogen, die zur Folge hat, dass sich die Vertiefungen 2 auf Grund der Oberflächenbeweglichkeit der Atome oberflächlich schließen, sodass eine geschlossene Schicht 4 entsteht, und sich gleichzeitig Hohlräume 3 unterhalb der Schicht bilden. Die Schicht 4 oberhalb der Hohlräume bildet im weiteren Verfahren schließlich die Schicht oder den Film aus halbleitendem Material.

Die den Schritten a) und b) zu Grunde liegende Technik ist in der Publikation Tsunashima, Y., Sato, T. und Mizushima, I., Electrochem. Soc. Proc. 17 (2000), pp. 532-545, beschrieben. Schritt b) wird vorzugsweise so gesteuert, dass sich dort, wo in Schritt a) Vertiefungen erzeugt wurden, ein durchgehender Hohlraum bildet, wobei der Zusammenhalt zwischen der Schicht 4 oberhalb der Hohlräume 3 und dem Rest des Substrats 1 durch absichtlich eingebaute Stege 3a in vorgegebenem Abstand gewährleistet wird. Die Stege entstehen an den Stellen, an denen in Schritt a) größere Abstände zwischen den Vertiefungen eingehalten wurden.

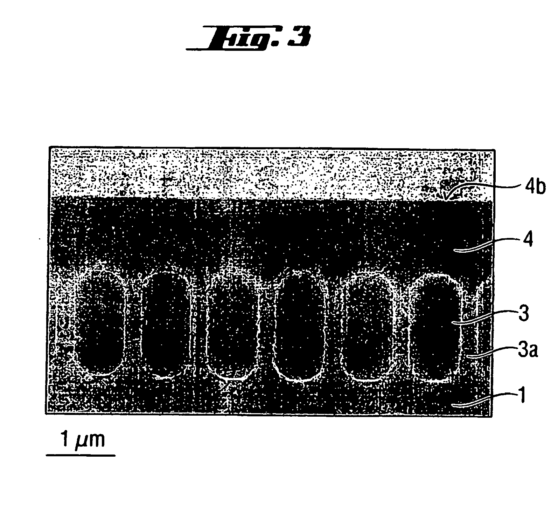

Falls die Vertiefungen in Schritt a) ohne größere Abstände an bestimmten Stellen erzeugt wurden, was besonders bevorzugt ist, wird die thermische Behandlung in Schritt b) derart gesteuert, dass die Oberfläche der Schicht 4 geschlossen ist, aber die aus den einzelnen Vertiefungen entstehenden individuellen Hohlräume 3 noch nicht zusammenwachsen. Fig. 3 ist eine SEM-Aufnahme eines Schnitts durch die entsprechend behandelte Oberfläche einer Siliciumscheibe. Sie zeigt eine geschlossene Schicht 4 über einer Schicht von individuellen, aus einzelnen Vertiefungen entstandenen Hohlräumen 3.

Die thermische Behandlung wird je nach Material zwischen 200 und 1500 °C durchgeführt, für 3 Sekunden bis 6 Stunden, wobei Temperatur und Zeitdauer zur Steuerung des Prozesses im oben geschilderten Sinn eingesetzt werden. Die thermische Behandlung kann in allen Atmosphären erfolgen, die die Bildung einer Oxidschicht ("native oxide") auf der Oberfläche des halbleitenden Materials verhindern, vorzugsweise in reduzierenden Gasen und Gasgemischen oder inerten Gasen und Gasgemischen. Bevorzugt ist eine Atmosphäre, die Wasserstoff oder Argon oder Mischungen aus Wasserstoff und Argon enthält. Die thermische Behandlung kann bei Atmosphärendruck oder reduziertem Druck erfolgen. Die Prozessbedingungen werden so gewählt, dass eine möglichst hohe Oberflächenbeweglichkeit der Atome des halbleitenden Materials erreicht werden kann.

Wird Silicium als Substrat verwendet, wird Schritt b) ausgeführt mit folgenden Einstellungen: Temperatur 700 - 1370 °C, bevorzugt 900 - 1250 °C, besonders bevorzugt 950 - 1150 °C, Druck 1.3-133 kPa (1 - 100 Torr), bevorzugt 1.3-67 kPa (1 - 50 Torr), besonders bevorzugt 6.7-27 kPa (5 - 20 Torr), Dauer 3 Sekunden bis 6 Stunden, vorzugsweise 1 Minute bis 30 Minuten. Die thermische Behandlung wird in einer nicht oxidierenden Atmosphäre durchgeführt, die vorzugsweise Wasserstoff oder Argon oder ein Gemisch der beiden Gase enthält.

Bevorzugt werden die Prozessbedingungen in Schritt b) so gewählt, dass gleichzeitig das Ausheilen von COPs "(crystal originated pits", Leerstellenagglomerate) im Substrat und insbesondere in dem Film bzw. in der Schicht 4 oberhalb der Hohlräume 3 erfolgt. Im Fall von Silicium sind dafür Temperaturen über 1000 °C notwendig, wie in der EP0829559A1 oder der US5935320 beschrieben.

Zusätzlich kann in diesem Schritt die Oberflächenbeweglichkeit der Atome des halbleitenden Materials durch sanften Beschuss mit Ionen niedriger Energie ("low-energy ion bombardment") erhöht werden, was zum schnelleren Schließen der Vertiefungen führt, oder niedrigere Temperaturen oder kürzere Zeiten ermöglicht.

Zusätzlich zur thermischen Behandlung kann, integriert in diese oder daran anschließend, eine epitaktische Schicht auf der geschlossenen Oberfläche abgeschieden werden. Damit kann beispielsweise eine Verkürzung der Prozesszeit erreicht werden. Die Abscheidung einer epitaktischen Schicht ist auch sinnvoll, falls die Oberfläche der Substratscheibe nach der thermischen Behandlung allein, beispielsweise für ein ggf. vorgesehenes anschließendes Bonding, nicht ausreichend glatt sein sollte, was sich nachteilig auf das Bonding auswirken kann. Es ist bekannt, dass eine epitaktische Schicht einer Dicke von < 0,5 µm kleine Oberflächeninhomogenitäten effizient ausgleicht, sofern die Abscheidetemperatur im Bereich der für die Hohlraumbildung geeigneten Temperaturen gewählt wird (T. Bearda, P. Mertens, M. M. Heyns, R. Schmolke, Jpn. J. Appl. Phys. 39 (2000) L841; R. Schmolke, M. Blietz, R. Schauer, D. Zemke, H. Oelkrug, W. v. Ammon, U. Lambert, D. Gräf, The Electrochem. Soc. PV2000-17 (2000) 3). Eine aus dieser Prozesskombination resultierende Schicht aus halbleitendem Material, bei der man gegebenenfalls aus einer Gesamtkostenbetrachtung eine Überschreitung der Zieldicke zulässt, kann mit einer geeigneten Nachbehandlung, wie sie im weiteren Kontext beschrieben wird, reproduzierbar und kontrolliert verringert werden.

Die zu erzeugende Schicht bzw. der Film 4 aus halbleitendem Material ist auf Grund ihrer bzw. seiner geringen Dicke mechanisch wenig stabil. Bevorzugt wird daher die Oberfläche des Substrats, unter der die Schicht von Hohlräumen erzeugt wurde, in einem weiteren Schritt bc) mit der Oberfläche eines Trägermaterials 5 verbunden ("Bonding"), wie in Fig. 2 schematisch dargestellt. Das Trägermaterial ist ein elektrisch isolierender Festkörper oder trägt zumindest eine elektrisch isolierende Schicht 6 an der Oberfläche. Als Trägermaterial dient bevorzugt ein Material aus der Gruppe Siliciumcarbid, Silicium-Germanium, Galliumarsenid, Quarz, Plastik, Glas und Keramik. Besonders bevorzugt ist Silicium als Trägermaterial. Im Fall des Siliciums ist eine elektrisch isolierende Schicht aus Siliciumoxid an der Oberfläche besonders bevorzugt. Bevorzugt ist auch, dass die Flächen von Substrat und Trägermaterial, die miteinander verbunden werden, die selben geometrischen Abmessungen haben. Ebenfalls bevorzugt ist eine scheibenförmige Gestalt des Trägermaterials.

Das Trägermaterial kann bereits einen eingebauten so genannten "internen Getter" enthalten, der im Bauelementprozess eingeschleppte Metallverunreinigungen bindet und von dem aktiven Bauelementebereich fernhält.

Die Verbindung des halbleitenden Materials 1 und des Trägermaterials 5 erfolgt mit den nach dem Stand der Technik bekannten Verfahren (Q.-Y. Tong and U. Gösele: "Semiconductor wafer processing", ISBN 0-471-57481-3).

Im letzten Schritt c) erfolgt die Trennung der Schicht bzw. des Films 4 vom Rest des Substrats 1, und zwar entlang der Schicht der Hohlräume 3. Aufgrund dieser Hohlräume geschieht die Trennung sehr materialschonend im Vergleich zu anderen Verfahren. Das Trennen erfolgt vorzugsweise thermisch, wobei die Hohlräume zusammenwachsen und die Trennung besonders schonend erfolgt.

Insbesondere im Fall der thermischen Trennung dürfen die aus den Trenches entstandenen, individuellen kleinen Hohlräume beim Bonding noch nicht vollständig zusammengewachsen sein, um die mechanische Stabilität der Substratscheibe für diesen Vorgang zu gewährleisten. Erst in einem thermischen Prozess nach oder während des Bonding-Prozesses dürfen die individuellen, kleinen Hohlräume zu bestenfalls einem großen verschmelzen. Dieser zweite thermische Schritt zum Trennen beinhaltet, falls es sich um ein aus Silicium bestehendes Substrat handelt, eine thermische Behandlung im Temperaturbereich von 800 bis 1370 °C, bevorzugt von 900 bis 1200 °C für eine Dauer von 3 s bis 4 h, bevorzugt von 1 bis 30 min. Dazu wird beispielsweise ein sog. Vertikalofen oder eine RTA-Anlage (Lampenofen für "rapid thermal anneal") eingesetzt. Die thermische Behandlung findet bei Atmosphärendruck oder reduziertem Druck in einer beliebigen Gasatmosphäre statt, vorzugsweise in einer reduzierenden oder inerten Gasatmosphäre, besonders bevorzugt in einer Atmosphäre, die Wasserstoff oder Argon oder eine Mischung aus Wasserstoff und Argon enthält. Um eine weitere Homogenisierung und Glättung der dünnen Schicht zu erreichen, kann es sinnvoll sein, die Dauer der thermischen Behandlung zu verlängern.

Es sind jedoch auch andere Verfahren bekannt, die verwendet werden können, um eine Trennung entlang der verschmolzenen Hohlräume zu ermöglichen. Unter den mechanischen Verfahren sind die Trennung durch Fluidstrahl (Sakaguchi et al., Solid State Technology 43 (6) (2000), pp. 88-92), die Anwendung von Scherkräften (Current et al., "Ultrashallow junctions or ultrathin SOI?", Solid State Technology, September 2000) und akustische Trennmethoden (unter Einsatz von Ultra- oder Megaschall) zu nennen. Auch eine chemische Spaltung durch Ätzabtrag der zwischen den Hohlräumen verbliebenen Stege durch geeignete Gase oder Flüssigkeiten (z. B. Flusssäure oder Mischungen aus Salpetersäure und Flusssäure) ist möglich. Möglich ist auch eine Kombination verschiedener Trennmethoden.

Bevorzugt ist auch eine Kombination des Schritts c) mit der Aufbringung einer epitaktischen Schicht auf der Oberfläche des halbleitenden Materials in einem Epitaxie-Reaktor, sodass die gewünschte Zieldicke der Schicht oder des Films eingestellt werden kann.

Besonders vorteilhaft erweist sich das erfindungsgemäße Verfahren bei der Herstellung von SOI-Strukturen. Es ermöglicht beispielsweise den Einsatz von Siliciumscheiben als Substrat, die aus tiegelgezogenen Einkristallen hergestellt wurden (CZ-Scheiben). Diese führen nach dem Stand der Technik dazu, dass die COPs, die die Siliciumscheiben enthalten, auch in der daraus hergestellten dünnen Siliciumschicht einer SOI-Scheibe zu finden sind, was in der Bauelementeherstellung zu Problemen führt. Aus diesem Grund werden nach dem Stand der Technik zweckmäßigerweise aus nach dem "Floating-Zone"-Verfahren tiegelfrei gezogenen Einkristallen hergestellte Siliciumscheiben (FZ-Scheiben) als Substratscheiben eingesetzt. Falls dies nicht geschieht, müssen die COPs in der dünnen Siliciumschicht nach der Herstellung der SOI-Scheibe durch eine thermische Behandlung, beispielsweise in einer Wasserstoffatmosphäre, ausgeheilt werden. Im Gegensatz dazu können beim erfindungsgemäßen Verfahren auch CZ-Scheiben problemlos als Substratscheiben verwendet werden, da beim thermischen Schließen der Oberfläche in Schritt b) gleichzeitig die COPs ausgeheilt werden können, was besonders bevorzugt ist.

Ein weiterer Vorteil des erfindungsgemäßen Verfahrens besteht darin, dass durch eine geeignete Anordnung und Form der in Schritt b) erzeugten Vertiefungen auch SOI-Scheiben mit ultradünnen Siliciumschichten mit einer Dicke von 50 nm oder weniger hergestellt werden können. Grundsätzlich kann, unter Beibehaltung des Tiefen/Breiten-Verhältnisses der einzelnen Vertiefung, eine umso dünnere und glattere Siliciumschicht hergestellt werden, je geringer Querschnitt und Abstand der Vertiefungen sind. Der Zusammenhang zwischen den geometrischen Parametern der Vertiefungen und der Dicke der herzustellenden dünnen Siliciumschicht lässt sich durch Variation der geometrischen Parameter experimentell ermitteln. Die notwendige periodische Strukturierung für den Dickenbereich unter 50 nm kann beispielsweise mit Nanoimprintverfahren, Elektronenstrahl-Lithographie, Röntgenstrahl-Lithographie oder Extrem-UV-Lithographie realisiert werden. Zukünftig wird es möglich sein, die periodische Strukturierung aufgrund der Fortschritte in der Photolithographie (weitere, neuere Verfahren sind in Entwicklung) auch im Bereich 50 nm und darunter hochgenau durchzuführen, damit kann die Dickenvariation solch dünner Schichten auf weniger als 5 % gedrückt werden.

Bereits heute können mit den oben genannten Verfahren geometrische Strukturen mit geometrischen Toleranzen ≤ 10 %, bevorzugt ≤ 5 % und besonders bevorzugt ≤ 1 % erreicht werden. Je enger die Toleranzen der geometrischen Strukturen sind, desto besser wird die resultierende Schichtdicken-Homogenität. Die Toleranz der Schichtdicke ist dabei generell geringer als die Toleranz der einzelnen geometrischen Strukturen. Damit sind Schichtdicken-Homogenitäten von 5 % und weniger erreichbar.

Durch die weitgehende Defektfreiheit und die hohe Oberflächenqualität der dünnen Siliciumschicht können aufwendige Nachbearbeitungsschritte reduziert oder vollständig eingespart werden, was zu einer erheblichen Kostensenkung bei der Herstellung der SOI-Scheiben führt.

Nach der Herstellung der SOI-Scheibe kann, wenn nötig, die Dicke der Siliciumschicht 4 eingestellt, d. h. erhöht oder erniedrigt werden. Zur Erhöhung der Schichtdicke kann beispielsweise eine epitaktische Siliciumschicht abgeschieden werden. Eine Verringerung der Schichtdicke ist mit den bekannten Verfahren der Politur, bevorzugt aber der Gasphasenätze oder der Oberflächenoxidation mit anschließender reduktiver Entfernung der Siliciumoxid-Schicht möglich. Die Homogenität der Schichtdicke bleibt dabei erhalten, sodass Schichtdicken von 20 nm oder weniger mit einer Schichtdickenhomogenität von 5 % oder weniger erhalten werden können.

Ebenso kann nachfolgend, wenn nötig, die Rauhigkeit der Oberfläche reduziert werden. Hierzu kann entweder eine Politur oder eine erneute thermische Behandlung erfolgen. Diese erfolgt in einer reduzierenden oder inerten Atmosphäre, die vorzugsweise Wasserstoff oder Argon oder eine Mischung von Wasserstoff und Argon enthält, bei Atmosphärendruck oder reduziertem Druck, im Temperaturbereich zwischen 1000 und 1250 °C für 10 Sekunden bis 60 Minuten in einem Batch-Ofen oder Lampenofen ("rapid thermal annealer", RTA). Batch-Öfen sind Vertikalöfen oder Horizontalöfen mit Booten für 50 - 250 Siliciumscheiben pro Fahrt. RTA sind Lampenöfen zum Anneal jeweils einer Scheibe pro Fahrt im "cassette to cassette" Betrieb.

Besonders vorteilhafte Eigenschaften der SOI-Scheibe können durch folgende bevorzugte Ausführungsformen des erfindungsgemäßen Verfahrens erreicht werden:

Beim Einsatz einer FZ-Scheibe als Substratscheibe kann eine SOI-Scheibe mit einer dünnen Siliciumschicht erhalten werden, die nicht nur frei von voids, sondern auch BMD-frei ist. BMDs (bulk-micro-defects) sind Sauerstoffpräzipitate, voids sind Konglomerate von Kristallleerstellen.

Wird als Substratscheibe eine hoch stickstoffdotierte CZ-Scheibe verwendet, kann eine, verglichen mit herkömmlichen CZ-Scheiben, höhere Resistenz gegen Gleitungen und Versetzungsbildung erreicht werden. Hoch stickstoffdotierte CZ-Scheiben sind CZ-Scheiben mit einem Stickstoffgehalt von 1·10¹⁴ - 5·10¹⁵/cm³. Hoch stickstoffdotierte Scheiben zeigen gegenüber CZ-Scheiben ohne Stickstoff eine deutlich erhöhte Resistenz gegenüber thermisch induzierten Gleitungen und Versetzungen und zeigen höhere BMD-Dichten (Gräf et al., ECS PV 2000-17, pp. 319-330; Ammon et al., ECS PV 94-10, p. 136; Sueoka et al., ECS PV 2000-17, pp. 164-179).

Eine weitere Möglichkeit ist, ein anderes Trägermaterial als monokristallines Silicium zu verwenden, z. B. polykristallines Silicium, Glas oder Keramik.

Besonders vorteilhaft ist das erfindungsgemäße Verfahren auch für die Erzeugung von Strukturen, die aus mehreren Schichten oder Filmen bestehen, anzuwenden. Zu diesem Zweck wird das Verfahren mindestens zwei mal hintereinander ausgeführt, wobei nach dem ersten Durchgang das Trägermaterial mit der darauf befindlichen ersten Schicht aus halbleitendem Material erneut als Trägermaterial verwendet wird, sodass auf die erste Schicht eine oder mehrere weitere Schichten aufgebracht werden.

### Beispiel

Die glatte, ebene Oberfläche einer Siliciumscheibe 1 (Fig. 2) wurde in Schritt a) des erfindungsgemäßen Verfahrens mit periodisch wiederkehrenden Vertiefungen ("Trenches") 2 versehen. Die Trenches hatten einen quadratischen Querschnitt mit einer Kantenlänge von ca. 0,5 µm, der Trench-Trench-Abstand betrug ca. 0,9 µm. Die Trenches waren in einem quadratischen Raster regelmäßig angeordnet. Die Trenches wurden durch Ionenstrahlätzen nach Stand der Technik derart erzeugt, dass eine Trenchtiefe von 3 µm entstand.

Anschließend wurde die strukturierte Oberfläche der Siliciumscheibe 1 in Schritt b) mittels einer 10 Minuten dauernden thermischen Behandlung in reiner Wasserstoffatmosphäre bei einem Druck von 13.3 kPa (10 Torr), einem Wasserstofffluss von 10 sccm und einer Temperatur von 1100 °C geschlossen. Dabei weiteten sich die aus den Trenches 2 entstandenen Hohlräume 3 parallel zur geschlossenen Scheibenoberfläche 4 um ca. 0,25 µm auf. Fig. 3 zeigt eine SEM-Aufnahme der entstandenen Hohlräume 3 und der darüber liegenden geschlossenen, perfekten und glatten Schicht 4. Diese geschlossene Oberfläche ist durch ihre Glattheit besonders gut für die Verbindung mit einer Trägerscheibe ("Bonding") nach Fig. 2 geeignet.

Die in Schritt b) vorbereitete Siliciumscheibe wurde in einem weiteren Schritt bc) mit ihrer Oberfläche 4b mit einer ebenfalls aus Silicium bestehenden, mit einer Siliciumoxid-Schicht 6 versehenen Trägerscheibe 5 mit einem kommerziell erhältlichen Bonder der Firma EVG, Schärding, Österreich, verbunden.

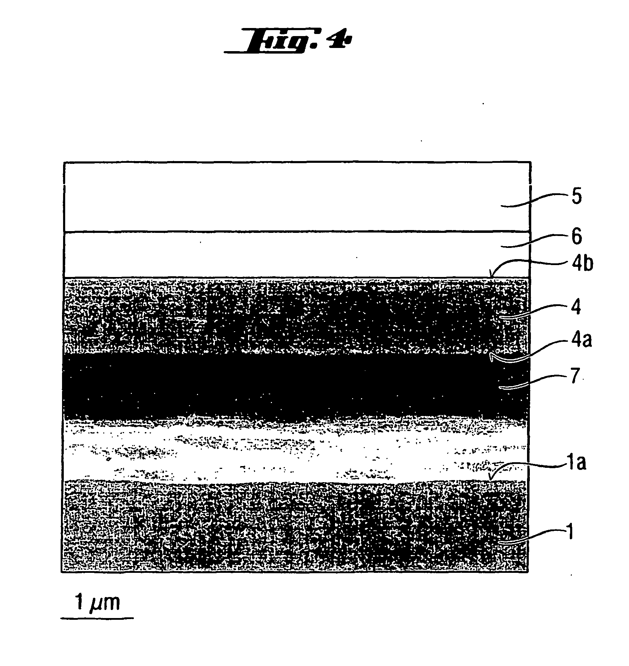

In Schritt c) wurden die über die Siliciumoxid-Schicht 6 verbundenen Siliciumscheiben einer weiteren thermischen Behandlung unterzogen. Dabei wurden die gleichen Bedingungen gewählt wie zum Schließen der Oberfläche in Schritt b). Durch diese thermische Behandlung verschmolzen die in Fig. 3 dargestellten Hohlräume 3, sodass ein durchgehender Hohlraum 7 (Fig. 4) entstand und die Siliciumschicht 4, die in Fig. 3 noch die Hohlräume 3 abdeckte, abgetrennt wurde. Fig. 4 zeigt die neu entstandene Oberfläche 1a der Substrat-Siliciumscheibe 1, darüber einen durchgehenden Hohlraum 7, der die erzeugte dünne Siliciumschicht 4 vollständig von der Siliciumscheibe 1 trennt. Die dünne Siliciumschicht 4 ist nun nur noch mit der Oxidschicht 6 der Träger-Siliciumscheibe 5 verbunden (5 und 6 schematisch dargestellt). Die Dicke der Schicht 4 beträgt ca. 1 µm, sie liegt lose auf dem verbleibenden Teil des Substrats 1. Im Vergleich zur Oberfläche 1a des verbleibenden Teils des Substrats ist die Oberfläche 4a der abgetrennten dünnen Siliciumschicht 4 bereits sehr glatt. Der Focus der Fig. 4 liegt auf der Oberfläche 4a, die für die Herstellung von elektronischen Bauelementen vorgesehen ist.

## Patentansprüche

1. SOI-Scheibe, bestehend aus einer Trägerscheibe und einer dünnen Siliciumschicht, **dadurch gekennzeichnet, dass** die dünne Siliciumschicht eine Dicke von 50 nm oder weniger, eine Dickenvariation von 5 % oder weniger und eine HF-Defekt-Dichte von weniger als 0,1/cm² aufweist.

2. SOI-Scheibe gemäß Anspruch 1, **dadurch gekennzeichnet, dass** die dünne Siliciumschicht eine Dicke von 20 nm oder weniger aufweist.

3. SOI-Scheibe gemäß einem der Ansprüche 1 oder 2, **dadurch gekennzeichnet, dass** die dünne Siliciumschicht frei von strahlungsinduzierten Defekten ist.

4. SOI-Scheibe gemäß einem der Ansprüche 1 bis 3, **dadurch gekennzeichnet, dass** die Trägerscheibe ein elektrisch isolierender Festkörper ist.

5. SOI-Scheibe gemäß Anspruch 4, **dadurch gekennzeichnet, dass** die Trägerscheibe aus einem Material besteht, das aus der Gruppe Quarz, Plastik, Glas und Keramik ausgewählt ist.

6. SOI-Scheibe gemäß einem der Ansprüche 1 bis 3, **dadurch gekennzeichnet, dass** die Trägerscheibe eine elektrisch isolierende Festkörperschicht an der Fläche aufweist, mit der die dünne Siliciumschicht verbunden ist.

7. SOI-Scheibe gemäß Anspruch 6, **dadurch gekennzeichnet, dass** die Trägerscheibe im Wesentlichen aus einem Material besteht, das aus der Gruppe Siliciumcarbid, Silicium-Germanium, Galliumarsenid und Silicium ausgewählt ist.

8. SOI-Scheibe gemäß Anspruch 7, **dadurch gekennzeichnet, dass** die Trägerscheibe im Wesentlichen aus Silicium besteht und eine elektrisch isolierende Festkörperschicht bestehend aus Siliciumoxid an der Fläche aufweist, mit der die dünne Siliciumschicht verbunden ist.

## Claims

1. SOI wafer, comprising a carrier wafer and a thin layer of silicon, **characterized in that** the thin layer of silicon has a thickness of 50 nm or less, a thickness variation of 5% or less and an HF defect density of less than 0.1/cm².

2. SOI wafer according to Claim 1, **characterized in that** the thin layer of silicon has a thickness of 20 nm or less.

3. SOI wafer according to either of Claims 1 and 2, **characterized in that** the thin layer of silicon is free of radiation-induced defects.

4. SOI wafer according to one of Claims 1 to 3, **characterized in that** the carrier wafer is an electrically insulating solid.

5. SOI wafer according to Claim 4, **characterized in that** the carrier wafer consists of a material selected from the group consisting of quartz, plastic, glass and ceramic.

6. SOI wafer according to one of Claims 1 to 3, **characterized in that** the carrier wafer has an electrically insulating solid layer at the surface to which the thin layer of silicon is bonded.

7. SOI wafer according to Claim 6, **characterized in that** the carrier wafer substantially comprises a material selected from the group consisting of silicon carbide, silicon-germanium, gallium arsenide and silicon.

8. SOI wafer according to Claim 7, **characterized in that** the carrier wafer substantially comprises silicon and has an electrically insulating solid layer consisting of silicon oxide at the surface to which the thin layer of silicon is bonded.

## Revendications

1. Plaquette SOI, se composant d'une plaquette de support et d'une mince couche de silicium, **caractérisée en ce que** la mince couche de silicium présente une épaisseur de 50 nm ou moins, une variation d'épaisseur de 5 % ou moins, et une densité de défauts HF inférieure à 0,1/cm².

2. Plaquette SOI selon la revendication 1, **caractérisée en ce que** la mince couche de silicium présente une épaisseur de 20 nm ou moins.

3. Plaquette SOI selon l'une quelconque des revendications 1 ou 2, **caractérisée en ce que** la mince couche de silicium est exempte de défauts induits par un rayonnement.

4. Plaquette SOI selon l'une quelconque des revendications 1 à 3, **caractérisée en ce que** la plaquette de support est un corps solide électriquement isolant.

5. Plaquette SOI selon la revendication 4, **caractérisée en ce que** la plaquette de support se compose d'une matière, qui est sélectionnée dans le groupe quartz, plastique, verre et céramique.

6. Plaquette SOI selon l'une quelconque des revendications 1 à 3, **caractérisée en ce que** la plaquette de support comprend une couche de corps solide électriquement isolant, sur la face à laquelle la mince couche de silicium est assemblée.

7. Plaquette SOI selon la revendication 6, **caractérisée en ce que** la plaquette de support se compose essentiellement d'une matière, qui est sélectionnée dans le groupe carbure de silicium, silicium-germanium, arséniure de gallium et silicium.

8. Plaquette SOI selon la revendication 7, **caractérisée en ce que** la plaquette de support se compose essentiellement de silicium et comprend une couche de corps solide électriquement isolant composée d'oxyde de silicium, sur la face à laquelle la mince couche de silicium est assemblée.
